(19) Europäisches Patentamt

European Patent Office

Office européen des brevets

(11) **EP 1 073 097 A2**

(12) **EUROPEAN PATENT APPLICATION**

(43) Date of publication:
**31.01.2001 Bulletin 2001/05**

(51) Int. Cl.7: **H01L 21/00**

(21) Application number: **00115828.6**

(22) Date of filing: **22.07.2000**

(84) Designated Contracting States:
**AT BE CH CY DE DK ES FI FR GB GR IE IT LI LU MC NL PT SE**
Designated Extension States:
**AL LT LV MK RO SI**

(30) Priority: **26.07.1999 JP 21130299**
**28.01.2000 JP 2000019875**

(71) Applicant: **Komatsu Ltd**
**Minato-ku, Tokyo 107-8414 (JP)**

(72) Inventors:
- **Chiba, Teiichirou**
  **Kanagawa-ken (JP)**
- **Mori, Akira**
  **Kanagawa-ken (JP)**

(74) Representative:
**Stenger, Watzke & Ring**
**Patentanwälte**
**Kaiser-Friedrich-Ring 70**
**40547 Düsseldorf (DE)**

(54) **Dot mark reading apparatus and reading method**

(57)　By irradiating a dot mark formation surface whose center portion is protruded with light obliquely from above or from just above, its irregularly reflected light is received by a CCD camera (18) disposed just above or obliquely above the irradiation surface. Image information sent from the CCD camera (18) is subjected to image processing so as to read the dot mark as a very bright spot. Consequently, the brightest spot of the reflected light can be recognized as a dot mark formation position easily and securely for a long time with a simple image processing. Further, a gap between respective dots can be reduced as compared to the conventional ones. In case where the aforementioned mark is minute, and the mark is formed on an inner face of a notch portion or peripheral face of a semiconductor wafer (W), the marks on all the wafers (W) can be read out while the plural semiconductor wafers (W) are accommodated in the cassette (11). Consequently, it is possible to read a dot mark having a peculiar shape whose part is protruded and to secure the visibility by the dot mark reading apparatus and method.

## FIG. 12

62.50×62.50 [ μm]

EP 1 073 097 A2

## Description

BACKGROUND OF THE INVENTION

1. Field of the Invention

The present invention relates to an apparatus and a method for reading minute dot marks formed in a predetermined region of a semiconductor wafer or metal surface, and more particularly to a reading apparatus and a reading method preferable for dot marks each having a protrusion from the semiconductor wafer surface or metal surface.

2. Description of the Related Art

In semiconductor manufacturing processes, it is necessary to set various and strict manufacturing parameters for each process. In order to control the parameters, a mark such as numeral, character, or bar code is displayed by dots on the surface of a part of a semiconductor wafer. The number of manufacturing processes of a semiconductor is 100 or more and, moreover, a number of element forming processes and planarization processes are performed in each process. The processes include, for example, resist application, projection of a pattern onto a resist in a reducing manner, resist development, and planarization of various films such as an insulating film and a metal film for filling a gap which occurs by copper wiring or the like.

The mark made by the above-described dots is generally formed by irradiating the surface of a part of a semiconductor wafer with a continuous pulse laser beam through an optical system. The marking is not limited to once. In order to show historical characteristics of manufacturing processes, minimum historical data required In the manufacturing processes is usually marked. Since the marking area on the semiconductor wafer is, however, limited to an extremely narrow region, the size of the dot and the number of dots to be marked are accordingly limited. The marking area, the size of a dot, and the number of dots are specified by the SEMI standard and the like.

As disclosed in, for example, Japanese Laid-Open Patent Publication No. 2-299216, information of a semiconductor wafer on which the dot marking is performed is read as a change in reflectance of an emitted laser beam of an He-Ne laser or a change in vibration of a heat wave of an ordinary laser beam. On the basis of the read Information, various manufacturing parameters in subsequent manufacturing processes are set. When the information is not accurately read and is read erroneously, therefore, all of semiconductor wafers become defective except for a coincidence. One of the factors of the unclearness is a small depth of the dot forming the mark. When the depth of the dot is small, the dot is buried by the above-mentioned formed film, so that the dot reading becomes impossible. Therefore, the dot needs to be so deep that it can be read clearly.

In order to obtain a certain depth of the dot, usually, a part of the semiconductor wafer is formed by melting and removing a part of the semiconductor wafer in a spot state with irradiation of a laser beam of a large energy so as to obtain a required dot depth. In this case, not only the dot size is expanded, but also the melted and removed substances are piled around the dot or scattered and adhered to the peripheral portion of the dot, and it may prevent element formation and exerts a large influence on the quality. Further, in case of dot marking performed by a YAG laser, due to the particularity of the YAG laser or the Q switch operation, a fluctuation is apt to occur in a laser output and a variation occurs in the depth or the size of a dot.

In order to solve the problems, for example, as disclosed in Japanese Laid-Open Patent Publication No. 59-84515 and 2-205281, the same point is repeatedly irradiated with a pulse laser beam of a relatively small energy. In the former Publication, in order to form a dot mark, while sequentially reducing the dot diameter pulse by pulse in order, the same point is repeatedly irradiated with a laser beam, thereby forming a deep dot. In the latter Publication, the frequency of a laser pulse of the first time is set to 1 kHz or lower and the frequency of a laser pulse subsequently emitted is set to a high repetitive frequency of 2 to 5 kHz to thereby form a dot having a depth of 0.5 to 1.0 $\mu$m or 1.0 to 1.5 $\mu$m.

To improve visibility of the dot, in addition to making the dot mark deep, a bottom surface of the dot mark in the surface of the semiconductor, for example, is formed uneven. As a result, light irradiated into an interior of the dot mark is reflected irregularly so as to decrease the brightness of an opening surface of the dot mark with respect to the surrounding of the dot mark, thereby clarifying brightness and darkness.

It is certain that one of the causes for unclear reading of the dot mark (hereinbelow called visibility) formed by by means of punching is the depth of the dot hole as described above. However, even when the dot is formed deep enough, in the case where a diameter of the opening of the hole is large or the dot depth is small relative to the hole diameter, the hole diameter is expanded even when a sufficient laser beam for obtaining a desired depth is projected and at the same time, the interior of the hole is entirely turned to a smooth curved face. As a result, a great deal of scattered lights are generated, only if the focal point of an objective lens installed on the reading apparatus is set to a bottom surface of the dot mark as in an ordinary manner. Thus, the above-mentioned reading means for reading with parallel reflecting lights may not be capable of distinguishing a difference between the dot mark and its surrounding.

On the other hand, in the above publication of Japanese Patent Laid-Open Publication No. 2-205281, although the dot depth is specifically described as 0.5 to 1.0 $\mu$m or 1.0 to 1.5 $\mu$m, the diameter of the dot is not described at all, and the shape of the dot is merely described as a Gaussian shape.

In the disclosure of Japanese Laid-Open Patent Publication No. 59-84515, since it is described that the diameter of the dot opening of the first time is 100 to 200 $\mu m$ and the depth is 1 $\mu m$ or less and, specifically, the laser beam is emitted four times, the depth of the dot in this case is at most 3 to 4 $\mu m$. In the drawings of the publication, the shape of the dot formed at a time is similar to the Gaussian shape.

It can be therefore considered that dots each having a required depth, whose sizes are uniform to a certain degree are formed by any of the marking methods disclosed in the above publications. The shape of the formed dot is, however, like a conventional shape and the diameter with respect to the depth is extremely large. Thus the visibility still lacks certainty. Since the reduction in size (diameter) of the dot to be formed is not disclosed in view of the above-mentioned publications, the disclosure does not intend to change the conventional dimension. The numerical values at the present time which are specified by, for instance, the SEMI standard are simply used. A substantial large increase in the number of dots and the dot forming area cannot be therefore expected.

As far as the dot marks are given to a processing surface of the integrated circuit as described above, it is not guaranteed that the above-described visibility of the dot mark is maintained even in an margin area. The reason is that the processing surface of the integrated circuit of the semiconductor wafer is more difficult to control than the other portions because as described above, diversified film formation processes and partial film removing processes are repeated, and especially a peripheral portion of the wafer is gripped or released repeatedly. Thus, the dot marks are buried by the film when it is formed or removed, or the mark depth is decreased because the film removal is carried out excessively. Consequently, the visibility tends to decrease each time when the multiple processings are carried out.

However, when the dot mark is formed in a smaller size than the conventional one, it is substantially difficult to form a deep hole with respect to the diameter thereof, thus the shape of the dot mark needs to be considered further. Particularly, the dot mark needs to be formed as small as possible and its visibility needs to be secured sufficiently.

Such a problem is related to not only the visibility of the dot marking to be formed in a surface of a semiconductor wafer, but also other minute electronic parts and mechanical parts in which marking is carried out by photolithography, etching, marking, or the like.

## SUMMARY OF THE INVENTION

Accordingly, the present invention has been achieved to solve such conventional problems and therefore, it is an object of the Invention to provide a dot mark reading apparatus and method capable of securing visibility of a minute dot mark, whose visibility cannot be estimated according to the conventional art, as well as that of dot marks of an ordinary size.

The dot marking on the conventional semiconductor wafer is carried out on a peripheral portion of the surface of thereof or a back surface thereof as described above. However, because the semiconductor wafer is gripped or released repeatedly in respective processes of the semiconductor element as described above, the peripheral portion is likely to be affected by various factors. Because the processing on a central portion of the wafer surface in which the element is to be formed Is subjected to strict control, the configuration of the wafer surface Is stabilized even after multiple processes are finished in formation or removal of various films as described above. However, the peripheral portion of the wafer is gripped mechanically or by suction, and therefore, film formation amount or film removal amount in that region, for example, cannot be controlled strictly.

Therefore, in case where the dot mark is formed by laser marking, film is accumulated in the dot hole so that the film on the dot bottom is likely to be thick. If the film removal amount is too large, the wafer body around the dot hole is scraped, so that the dot depth is decreased. Consequently, the visibility decreases as described above. This is not limited to a dot mark formed by laser beam but the same thing can happen to the dot mark formed by photolithography or etching.

Thus, the inventors of the present invention considered that if the dot mark could be formed in a center of the semiconductor wafer which was an element formation region having the least change in the surface condition, the visibility was easy to secure. However, it is impossible to form the dot mark directly in the semiconductor element formation region. Particularly, a region to which the inventors pay attention is a scribe line which is a cutting region for cutting a semiconductor wafer into a unit of element. Because the scribe line is controlled strictly in respective processes of integrated circuit manufacturing as described above, it is maintained in such a state that is very similar to an exposed silicone. Thus, this scribe line can be consideredto be an ideal place for the dot marking region.

As a result of accumulated considerations by the inventors of the present invention, it has been found that there is a marking region which enables effective reading without an influence on the semiconductor wafer from outside due to transportation or moving and in which a surface condition thereof is not changed much. Although the scribe line is an ideal portion as the dot marking region as described above, when the dot mark is read out, the semiconductor wafer has to be taken out of the cassette and set on a reading table. Although pollution on the semiconductor wafer is not conspicuous because usually these operations are carried out by a robot, the frequency of taking out and into the cassette is desired to be minimum.

As a result of investigation for a new region which can be marked of the semiconductor wafer in considerations of these points, there has been found a region preferable for marking, in which a state similar to an exposed silicone is always maintained and which can be read out in a state that the wafer is accommodated in a wafer cassette.

An ordinary wafer cassette is constructed of a plastic case which contains a plurality of wafers in parallel on multiple stages with a predetermined gap allowing a hand portion of a robot to be inserted in and removed from. There is an opening for wafer insertion and removal in the same case, so that a part of the peripheral face of the semiconductor wafer accommodated in the cassette is exposed outside through the aforementioned insertion and removal opening. Thus, if the dot mark can be formed in that exposed portion, the dot mark can be read out with the semiconductor wafers being accommodated in the cassette. The Inventors of the present invention also paid attention to the exposed portion.

The peripheral faces of front and rear surfaces of the semiconductor wafer are chamfered. If the dot marks can be formed in a chamfered portion or the peripheral face between the front and rear surfaces, these portions are preferable as a marking region in every viewpoint. As a result of further Investigation, it was considered that the target face is an Inner face of a notch cut out in the peripheral face of the wafer in a substantially V shape, it can be a more preferable marking region than the chamfered portion and peripheral face. If a desired number of the dot marks are formed in such a narrow region, however, the marking amount becomes very small in a case where a conventional dot mark of 100 to 200 $\mu$m in diameter is employed. Specifically because not only character information composed of 2D code but also a large amount of data can be input, the dot marks to be marked on the aforementioned region must be reduced extremely with respect to the conventional one.

If the minute dot marks can be formed in the scribe line or marking region of the peripheral face of the wafer, a conventionally unestimated great advantage, which will be described, can be expected. That is, the quantity of the dot marks which can be formed in the marking region increases much more than the conventional one, so that the 2D code can be used freely. Further, the quantity of information bytes can be increased regardless of whether it is 1D code or 2D code. Further, the same Information can be written not only once but also twice or three times.

As a result of detailed consideration and analysis on the conventional various types of the dot marking apparatus, methods and dot configurations, the inventors of the present invention have found that major factors for securing an excellent visibility relative to the dot mark of minute size are dot configuration and characteristic of the reflected light based on that configuration. Further, without employing the conventional dot configuration, it has been found that only if at least a part of the dot mark is protruded from a mark formation surface, a sufficient visibility can be secured, and further that the visibility is not affected even when the gap between the marks is decreased.

Even when the conventional method is applied to the dot mark formed by laser beam, the dot mark having a minute size and ideal protruded configuration cannot be obtained. As an example of a special method, it can be considered to use a minute marking apparatus comprising a laser oscillator, a beam homogenizer for homogenizing an energy distribution of laser beam projected from the laser oscillator, a liquid crystal mask controlled so as to allow the laser beam to pass through/not pass through depending on an indication of a pattern, a beam profile converting means for forming and converting energy density distribution of the laser beam to a desired distribution shape for each dot corresponding to a pixel of the liquid crystal mask, and a lens unit for making image formation of a transmission beam of the liquid crystal mask on the surface of the semiconductor wafer for each dot.

The energy distribution of the laser beam emitted from the pulse laser oscillator is homogenized by the beam homogenizer and the liquid crystal mask in which the maximum length of a pixel is 50 to 2,000 $\mu$m is driven so as to form a desired pattern. Then, a laser beam whose energy distribution is homogenized by the beam homogenizer is projected to the liquid crystal mask. The laser beam for each dot passing through the liquid crystal mask is condensed to 1 to 15 $\mu$m in maximum length of one dot by the lens unit and make image formation on the surface of the semiconductor wafer.

The aforementioned semiconductor wafer includes not only a silicone wafer by itself but also wafers coated with oxide film ($SiO_2$) or nitride film ($SiN$), wafer subjected to epitaxial growth, wafers having a surface formed of gallium arsenate, indium phosphorous compound.

As for the visibility of an ordinary dot mark, it can be understood easily that the visibility is high in a case where there is a large difference in light reflection direction and reflection amount between the dot mark and its surrounding. Thus, if the dot hole is deep relative to the diameter of the opening as described above, the visibility is increased. Since an incident light at a predetermined angle into the dot hole is reflected irregularly not in uniform directions but in diversified directions, reflected light emitted from the hole opening decreases. When it is assumed that the surrounding portion of the hole is of smooth surface, reflected light by the surrounding portion is reflected in a predetermined direction, so that the brightness is intensified. When a difference in brightness is high, the visibility can be also high.

However, it is very difficult to increase a depth of the dot mark relative to the diameter of the dot hole to form a dot mark whose maximum width is 1 to 15 μm. Because such a dot mark is difficult to form, it is desirable to secure visibility with a dot configuration, which is easier.

As a result of accelerated considerations and experiments, the inventors found that when light is projected obliquely from above to the protrusion and its surrounding, and light reflected irregularly by that irradiation surface is received by an image receiver, the brightness at a vertex of the protrusion is extremely higher than that of the surrounding. If parallel coherent light is projected to the dot mark composed of a conventional hole configuration in order to read the dot mark by that reflected light, the hole portion in the center is black while the surrounding changes continuously from a ring-like bright portion to brighter portion. Further, while a swollen portion on the ring around the hole generates shade, so that the dot is difficult to recognize due to the difference of brightness. If light is projected to the dot mark swollen from the light irradiation surface so as to read the dot mark by the scattered light, the vertex of the dot mark shines with a high brightness around a point, so that the difference of brightness relative to the surrounding increases extremely. A number of experiments were conducted on a premise that an existence of the dot mark would be recognized securely even when the dot is minute.

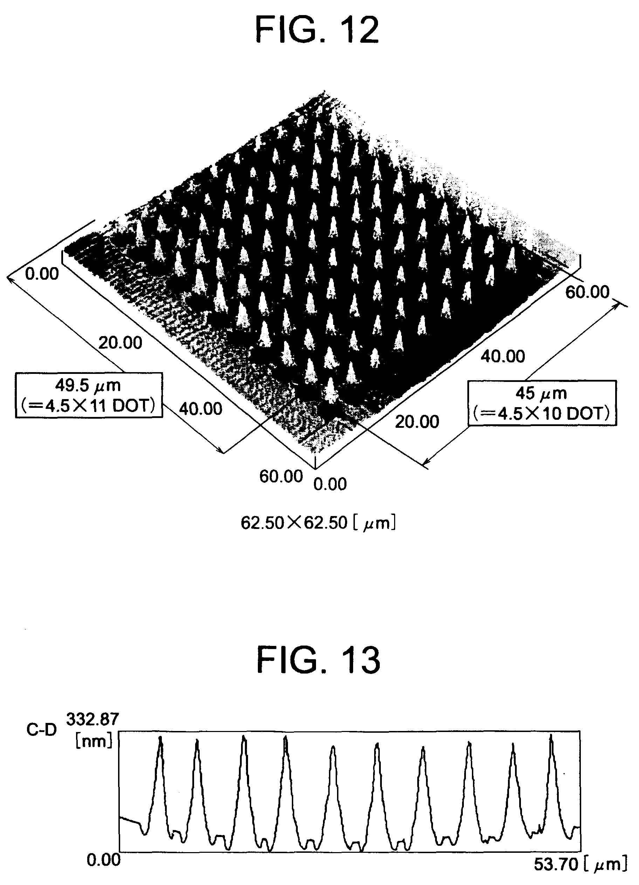

FIGS. 12 and 13 illustrate a typical shape and arrangement of dot marks formed by the method of the invention. Fig. 12 is a stereoscopic view observed by an AFM and Fig. 13 is a cross section thereof. According to this embodiment, the shape of each dot mark formed on the surface of the semiconductor wafer W is a square of 3.6 μm and the interval between neighboring dots is 4.5 μm. As understood from the diagrams, almost conical-shaped dot marks each formed by a laser beam split in correspondence with each of pixels of the liquid crystal mask 4 are formed on the surface of the semiconductor wafer W. Moreover, the dot marks of 11 x 10 are arranged in order and their heights are almost the same. This is because the energy distribution of the laser beam emitted to the liquid crystal mask 4 is homogenized by the beam homogenizer 3.

The dimension of the microdot mark according to the invention is as described above. That is, the maximum length along the surface of the semiconductor wafer to be marked is 1 to 15 μm and the height of the protrusion is 0.01 to 5 μm. The values are obtained by various experiments and are within the range from the minimum to the maximum necessary to assure the limit of the visibility of an existing optical sensor and the degree of freedom of the marking area.

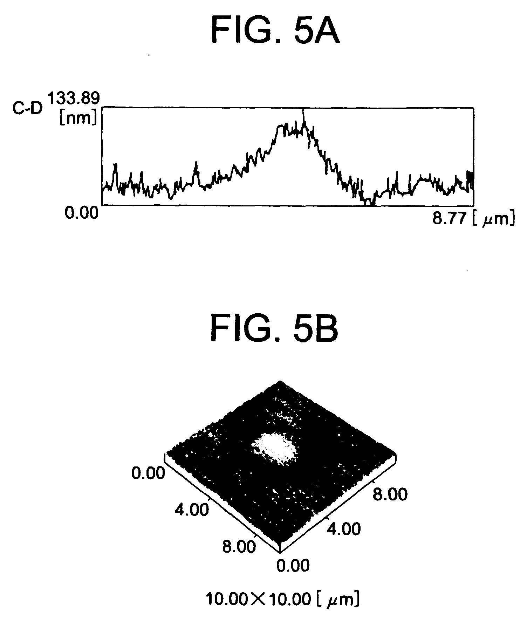

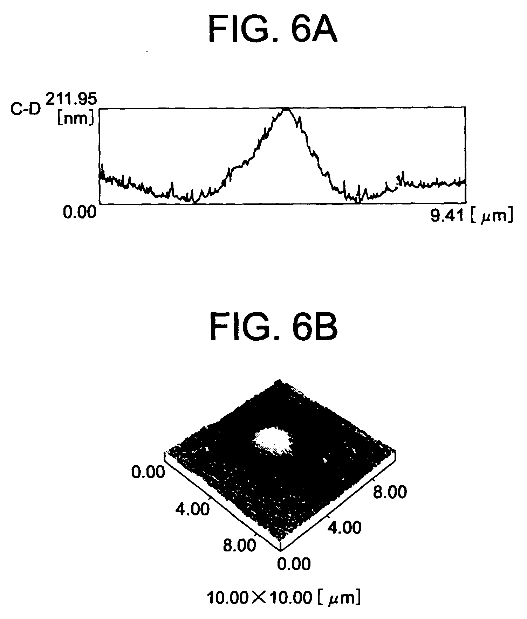

FIGS. 5 and 6 show dot configurations which can be obtained when a laser beam pulse is changed if the diameter of the dot to be irradiated on the surface of the semiconductor wafer is 7.2 μm and the energy density of the laser beam is 1.19. 1.42 (J/cm$^2$) under the marking condition described below.

    Laser medium: Nd, YAG laser
    Laser wavelength: 532nm
    Mode: TEM00
    Average output: 4W @ 1KHz
    Pulse width: 100ns @ 1KHz

Laser beam for use includes second harmonic from the YAG laser oscillator or YV04 laser oscillator, and laser beam from a titan sapphire laser oscillator or the like.

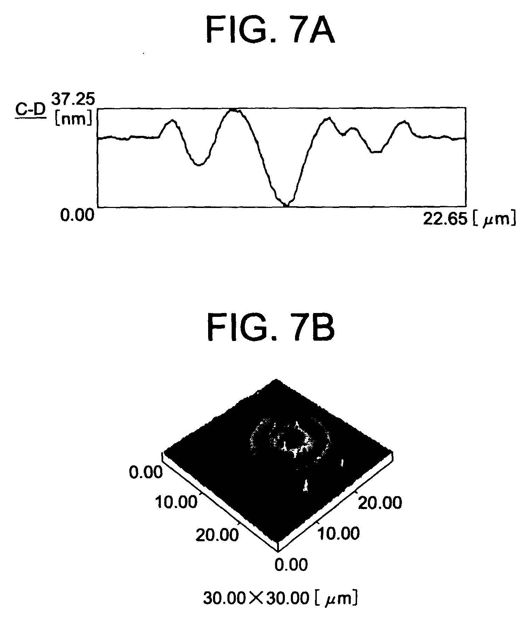

As shown in FIGS. 5 and 6, although an annular concave portion is provided in the surrounding, the center portion is protruded high so that a substantially conical shaped portion is produced. A difference of brightness relative to the surrounding is high and it can be understood that a sufficient visibility is secured. The dot mark shown in FIG. 7 has a conventional hole configuration. Despite it has the same dot width as the dot mark shown in FIGS. 5 and 6, the energy density is 0.96(<10) J/cm$^2$. Therefore, the center portion has a large concave portion and a difference in height at the uneven potion is much smaller than the aforementioned dot mark, so that the visibility is inferior.

According to the present invention, a method of reading a change in reflectance by laser beam irradiation as the conventional example may be employed, a change in transmission light by X-ray irradiation can be read for example. However. it is preferable to irradiate with ordinary visible light and receive a light reflected by an optical reflection surface of the dot mark through an objective lens. The light emitted from a light source is projected to the dot mark formation surface through an optical system. This irradiated light is reflected by the reflection surface of the dot mark and the scattered light by the vertex of the dot mark having a protruded shape is converged and received by an image receiver. As for the distribution of the amount of light received by the image receiver, the amount of light scattered by the dot mark is much larger than the amount of light reflected by the surrounding of the mark. Therefore, the scattered light can be distinguished from the other reflected lights sufficiently even in a subsequent image processing, so that the dot marks can be read out accurately.

Here, a numerical aperture of the objective lens is preferred to be 0.1 or less. If the numerical aperture of the objective lens comes near 0.13, a field of vision widens so that image processing accuracy drops slightly though position adjustment of a reading objective region is facilitated. However, the dot mark having a particular shape which the present invention employs has an extremely large difference in brightness relative to the surrounding. Therefore, it has no any special disadvantage in practical use for reading a light bright point concentrated to a center position of the dot mark. Even if the numeral aperture of the objective lens is less than 0.1 so that the focal depth is too large, the dot mark can be recognized in a wide region because the difference in brightness between the light reflected by the surface of the reading object and the light scattered by the surface of the dot mark.

The electromagnetic wave in the present invention includes infrared ray and X-ray as well as visible light having ordinary wave length. For reading infrared ray, an infrared ray camera is employed as its image receiver. Taking advantage of a phenomenon that thermal capacity of the swollen portion is larger than that of the other flat portion, it can be read securely by receiving an image of that swollen portion and then carrying out image processing of that received image. Because X-ray transmission amount of the swollen portion is different from that of the flat portion, it is possible to carry out the same reading by receiving the transmission lights and comparing the X-ray transmission amounts.

To achieve the above object, according to a first aspect of the present invention, there is provided a dot mark reading apparatus, wherein an electromagnetic wave is projected to a dot mark formation surface and reflected waves or transmission waves are received by a wave receiver so as to read the dot marks by carrying out image processing of image information sent from the wave receiver, at least a part of the dot mark has a protruded portion which is protruded from the dot mark formation surface, the dot mark reading apparatus comprising: an electromagnetic wave projection system for projecting the electromagnetic wave obliquely from above or from just above to the dot mark formation surface; a wave receiver for receiving scattered wave or transmission wave from the dot mark formation surface; and an image processing means for carrying out image processing of image information from the wave receiver.

A first important point of the present invention is that part of each dot mark which is an object to read has a protrusion which is protruded upward from the mark formation surface. A second important point is that the scattered light or transmission light of an electromagnetic wave projected obliquely from above or from just above the electromagnetic wave projection surface is received. When the scattered light by ordinary light projection is received, the same principle as a case where an image is recognized by visually watching is applied. Thus, a focal point of the image receiver only has to be adjusted to an irradiation surface like an ordinary video camera and a precision focal point adjustment may only be made approximately onto the irradiation surface unlike the conventional ones. Because only the center portion of the mark shines with a high brightness due to a peculiar configuration of the dot mark, the dot mark can be recognized securely as a single bright spot.

When the electromagnetic wave is projected obliquely from above or from just above the electromagnetic wave projection surface to the dot mark formation surface of the semiconductor wafer, most of the electromagnetic wave received by the wave receiver disposed just above or obliquely above the dot mark of the semiconductor wafer are mainly scattered waves at the protruded portion of the dot mark, because the surrounding of the dot mark is subjected to mirror processing. Consequently, light projected to most of the peripheral face of the protruded portion and a smooth surface around the mark become a regularly reflected light and does not enter the wave receiver. Therefore, the electromagnetic wave image received by the wave receiver is concentrated to a point in the center of the dot mark.

This is different from the dot mark composed of a conventional hole configuration as shown in FIG. 7, in which when an optical image is formed by reflected light of irradiation light parallel to each other, the center portion is dark and the surrounding is slightly bright in a shape of a ring while a further outside portion becomes brighter, such that the brightness changes continuously. That is, as shown in FIGS. 5 and 6, the dot mark can be recognized with a highly bright spot concentrated to a point in the center of the mark. Thus, not only the visibility is improved but also the gap between the dot marks can be reduced as compared to the conventional ones. Consequently, the number of the dots or information amount can be largely increased despite the marking region of the same area as the conventional ones.

Further, according to the first aspect of the present invention, there is provided a dot mark reading, wherein the image processing means has a recognition section for recognizing the scattered wave or transmission wave from the protruded portion of the dot mark as dot information of a minimum unit.

For example, according to a conventional dot mark reading method using a CCD camera, the CCD camera receives light in a circular shape having a difference of intensity or whose part is discontinuous circular, and then arithmetic operation based on an empirical rule is carried out so as to recognize it as a single dot mark. On the contrary, the recognition section of the image processing means of the present invention recognizes directly a high brightness portion having a difference in brightness as a dot mark composed of minimum information unit without carrying out complicated arithmetic operation like the conventional image processing. Thus, it is only necessary to convert a position in which the CCD camera receives light of high brightness corresponding to the dot mark and a position in which it receives light of high brightness corresponding to an adjacent dot mark as information. Thus, it is not necessary to set up a shape of the dot mark preliminarily and recognize the set shape as a dot mark through the complicated arithmetic operation.

Furthermore, according to the first aspect of the present invention, there is provided a dot mark reading apparatus, wherein the electromagnetic wave projected to the dot mark formation surface is incoherent light. If incoherent light is employed, an entire irradiation surface is irradiated to an entire surface of the irradiation surface with averaged light with directivity so that the shade of the dot mark is generated less than a case where coherent light is employed. Further, according to the present invention, the coherent light may be employed and particularly when the dot mark is irradiated just from above, the coherent light has more advantage.

Still further, according to the first aspect of the present invention, there is provided a dot mark reading apparatus, wherein the dot mark is formed on a peripheral face or an inner face of a notch portion of a semiconductor wafer, the dot mark reading apparatus further comprising: a wafer cassette which contains a plurality of the semiconductor wafers each having part of the peripheral face exposed; a stage containing the cassette placed horizontally, the stage being moved in X-axis, Y-axis and Z-axis directions and rotated around its vertical axis; and the electromagnetic wave projection system and the wave receiver disposed on the peripheral face of the cassette so as to oppose an exposed peripheral face of one of the plurality of the semiconductor wafers accommodated in the cassette.

This structure concerns the most advantageous and efficient dot mark reading apparatus of the present invention, which enables reading, which was impossible in the conventional dot mark reading apparatus of this kind. The dot mark which is a reading object of the present invention as described above enables writing and reading of the dot marks having sufficient information amount in a narrow region which could not be expected. According to the present invention, the dot mark is formed on the peripheral face of the semiconductor wafer, particularly on an inner face of a notch portion formed in the peripheral face. Because usually, the front and rear sides of the notch portion are chamfered, the dot mark is formed in the chamfered portion and a central portion between the front and rear chamfered portions respectively.

A plurality of the semiconductors having the dot marks in the notch portions are accommodated in parallel to each other in a dedicated cassette with a predetermined gap. The notch portions are exposed from the cassette. The cassette containing the plurality of the semiconductor wafers is fixedly placed horizontally at a predetermined position on the stage such that the respective wafers are horizontal. The stage can be moved in X-axis, Y-axis and Z-axis and rotated with respect to its vertical axis. The cassette can be moved in three dimensional directions and rotated with respect to an axis passing through a center of the wafer. An irradiation optical system and an image receiver are disposed on the peripheral portion of an installation space of the cassette so as to oppose one of the plural semiconductor wafers accommodated in the cassette.

According to a second aspect of the present invention, there is provided a dot mark reading method for reading the dot mark effectively by means of a device having the above-described structure.

According to the second aspect of the present invention, there is provided a dot mark reading method, wherein an electromagnetic wave is projected to a dot mark formation surface and reflected wave or transmission wave thereof are received by a wave receiver so as to read a dot mark by carrying out image processing of images sent from the wave receiver, the dot mark reading method comprising steps of: forming the dot mark having a protrusion which is protruded upward from the dot mark formation surface; setting the dot mark formation surface on which the dot mark is formed at a mark reading position; irradiating the electromagnetic wave on the formation surface through an electromagnetic wave projection system; receiving a scattered wave or transmission wave of the projected electromagnetic wave from the electromagnetic wave projection surface by means of the wave receiver; and carrying out image processing of the electromagnetic wave received by the wave receiver as image information.

According to this method, light is projected to the dot mark formation surface and then, the reflected light is received by the image receiver and an image sent from the image receiver is subjected to image processing so as to read the dot mark. The mark formation surface of the semiconductor wafer including a dot mark whose center portion is swollen is irradiated with light projected obliquely from above or from just above through an irradiation optical system. At this time, the irradiation light is desired to be not parallel light but light near natural light and irradiates the irradiation surface having a predetermined area all at once.

A portion around the dot mark swollen from the surface of the light irradiation surface irradiated with light is usually subjected to mirror processing. Light incident at an angle $\theta$ with respect to the normal is reflected at the same angle $\theta$. On the other hand, most light incident to the dot mark is scattered in multiple directions. Therefore, if light projected obliquely from above or from just above the irradiation surface is received just above the dot mark or obliquely above it, the reflected light around the dot mark is not received by the image receiver, but part of the scattered light reflected by the dot mark surface is received as light flux having a certain cross sectional area. If this light flux is converged through the optical system so as to form an optical image, an optical image having a large difference of brightness from the surrounding can be obtained. Consequently, even a minute dot mark can be recognized securely.

Further, according to the second aspect of the present invention, there is provided a dot mark reading method further comprising a step of recognizing information corresponding to a single one of the dot mark of the image information as minimum information unit. Because the dot mark read according to the present invention has a peculiar shape as described above, its image information can be distinguished from the surrounding image information clearly. Thus, the image information corresponding to the dot mark can be recognized directly as a dot mark. Therefore, as described above, it is not necessary to memorize a model shape for an image obtained from the dot mark preliminarily in the image processing section or carry out arithmetic operation for comparative operation with the model shape.

Furthermore, according to the second aspect of the present invention, there is provided a dot mark reading method, wherein the electromagnetic wave to be projected to the dot mark formation surface is incoherent light. When the incoherent light is projected to the irradiation surface, no interference fringe is generated on the image receiving surface. Further, it is irradiated substantially equally to the irradiation surface within a predetermined area regardless of the irradiation angle. Thus, it is possible to prevent an occurrence of shade of the dot mark, so that a clear image can be obtained.

The second aspect of the present invention specifies that the dot mark is formed on an inner face of the notch portion of the semiconductor wafer or a peripheral face of the wafer. The inner face of the notch portion or the peripheral face of the semiconductor wafer is least affected by any of diversified processings in the semiconductor manufacturing process as described above and is an ideal marking region for maintaining the dot mark for a long time. However, when it is intended to form the dot marks of desired information amount in this region, its shape and size need to be minute. If such a shape can be realized, this becomes a region in which a larger amount of information than that of the conventional dot marks can be written.

Further, according to the present invention, information o f the dot marks can be read without moving plural semiconductor wafers more than necessary.

That is, the wafer cassette accommodating the plural semiconductor wafers with parts of the peripheral faces thereof being exposed is placed horizontally on a stage which is movable in the X-axis, Y-axis, and Z-axis directions and rotated with respect to the vertical axis. Then, the electromagnetic wave projection system and wave receiver are fixedly disposed so as to face an exposed peripheral face of one of the semiconductor wafers.

The electromagnetic wave to be projected to the exposed peripheral face of part of the semiconductor wafers through the electromagnetic wave projection system is projected obliquely from above or from just above the dot mark formation surface. On the other hand, the wave receiver is installed so as to be capable of receiving the scattered light from just above or obliquely from above the electromagnetic wave projection surface. That is, the electromagnetic wave received by the wave receiver is not a reflection wave reflected at the same angle as the projection angle, but the scattered light arriving from the surrounding. Therefore, the incident angle at this time is not coincident with a light receiving angle with respect to the normal at an incident point. When receiving transmission light such as X-ray, the wave receiver is located on the electromagnetic wave projection axis and disposed on a back of the exposed peripheral faces of part of the semiconductor wafers.

If the dot mark on a single semiconductor wafer within the wafer cassette placed horizontally on the above stage whose peripheral face is partially exposed is read out, the stage is moved in the X-axis, Y-axis and Z-axis directions and rotated with respect to its vertical axis. Consequently, the semiconductor wafer is located accurately at a reading position (a peripheral face or an inner face of the notch portion of the wafer) which is an object for the next reading. Then, the scattered wave or transmission wave of an electromagnetic wave projected from the electromagnetic wave projection system is received and its image information is subjected to image processing so as to read out the dot marks.

Still further, according to the second aspect of the present invention, there is provided a dot mark reading method, wherein a maximum width of the dot mark is 1 to 15 μm. This is the limit size that can secure the visibility and the size necessary for forming dot marks having a predetermined information amount in a narrow marking region. Such a minute dot mark is not restricted by the size of the dot mark formation region but enables writing of predetermined information. As a result, selection of information is increased extremely.

BRIEF DESCRIPTION OF THE DRAWINGS

FIG. 1 is an explanatory diagram schematically showing a typical laser marking apparatus for forming a dot mark whose center is protruded, and which is applied to the reading method of the present invention.

FIG. 2 is an explanatory diagram showing an example of arrangement of characters and 2D codes of the dot marks formed in a scribe line of the semiconductor wafer.

FIGS. 3A to 3C are an example showing schematically a dot mark whose center is protruded and explanatory diagrams showing a characteristic of a light reflected on the dot mark and optical intensity distribution thereof.

FIGS. 4A to 4C are an example schematically showing a dot mark whose center portion is a concave hole and whose surrounding is swollen like a ring and explanatory diagrams showing a characteristic of light reflected on the dot mark and optical intensity distribution thereof.

FIGS. 5A and 5B are an observatory sectional view and a three-dimensional view by AFM showing a typical minute dot mark whose center is protruded.

FIGS. 6A and 6B are an observatory sectional view and a three-dimensional view by AFM indicating another typical other minute dot mark whose center is protruded.

FIGS. 7A and 7B are an observatory sectional view and a three-dimensional view by AFM showing a dot mark of a conventional hole configuration whose center is protruded.

FIG. 8 is a plan view schematically showing an arrangement of the dot marks whose center portions are protruded read from their upper surfaces according to the present invention.

FIG. 9 is a plan view schematically showing an arrangement of the dot marks whose center portions are concave holes read from above according to the present invention.

FIG. 10 is an explanatory diagram schematically showing a structure of a typical dot mark reading apparatus of the present invention.

FIG. 11 is an explanatory diagram showing a procedure for reading the dot marks by the reading apparatus.

FIG. 12 is a three-dimensional view when observing an arrangement of the minute dot marks whose center portions are protruded by means of the AFM.

FIG. 13 is a sectional view of FIG. 12.

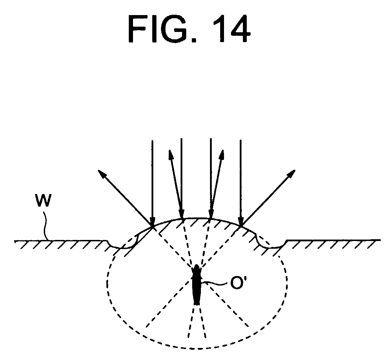

FIG. 14 is a sectional view schematically showing an example of another reading mechanism for the dot mark which is partly protruded and which contains a focal point internally, applicable to the present invention.

## DESCRIPTION OF THE EMBODIMENTS

First, a typical laser marking apparatus that produces minute dot marks according to embodiment of the present invention will be described in detail with reference to the accompanying drawings. Of course, the present invention can be applied to not only minute a dot mark but also a dot mark of an ordinary size. In this embodiment, incoherent beam is used as an irradiation electromagnetic wave to be projected to a dot mark formation surface.

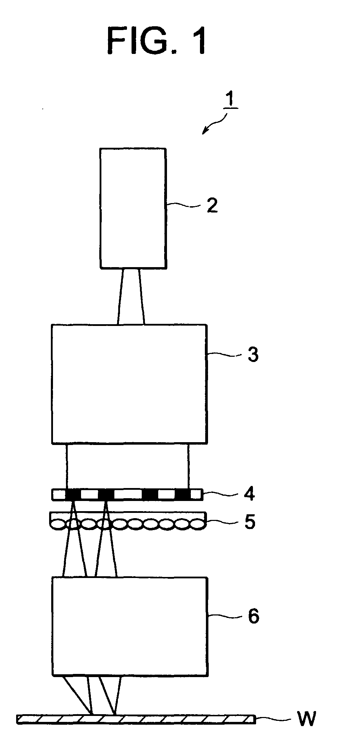

FIG. 1 is an explanatory diagram schematically showing a laser marking apparatus for forming a minute dot mark of 1 to 15 μm.

In that figure, reference numeral 2 denotes a laser oscillator, reference numeral 3 denotes a beam homogenizer, reference numeral 4 denotes a liquid crystal mask, reference numeral 5 denotes a beam profile converter, reference numeral 6 denotes a image-formation lens unit, and reference symbol W denotes a semiconductor wafer. The semiconductor wafer W mentioned in this specification generally refers to not only a silicone wafer but also a wafer having oxide film or nitride film formed on its surface, epitaxial-growth semiconductor wafer, semiconductor wafers having film formed of gallium arsenate, indium phosphorous compound or the like.

In dot marking on a surface of the semiconductor wafer using the laser marking apparatus 1 of this embodiment, a laser beam having a Gaussian energy density distribution emitted from the laser oscillator 2 is homogenized by the beam homogenizer 3 to that having a top-hat shaped energy density distribution whose peak values are almost the same. The surface of the liquid crystal mask 4 is irradiated with the laser beam having the energy density distribution homogenized as mentioned above. As widely known, a required marking pattern can be displayed on the liquid crystal mask 4. The laser beam passes through a pixel portion which is in a light transmittable state in a display region of the pattern. The energy density distribution of each transmitted light split on the pixel unit basis has the same shape as that homogenized by the beam homogenizer 3 and is uniform.

An optical component for allowing a laser beam having, for example, a Gaussian energy density distribution to have a shape of a homogenized energy density distribution is generically called the beam homogenizer 3. For example, there is an optical component of a system for irradiating the surface of an entire mask by using fly's eye lens, binary optics, or cylindrical lens or scanning the surface of a mask by performing a mirror operation by an actuator such as a polygon mirror or a mirror scanner.

The area irradiated per time in the liquid crystal mask 4 is equal to the number of dots of 10 x 11. All of the dots are irradiated with a laser beam at a time. Since such number of dots is not often enough for necessary dots, the mark pattern may be divided into a plurality of sections and the liquid crystal mask is allowed to sequentially display the sections. By switching and combining the sections, the whole mark pattern may be formed on the wafer surface. In this case, in order to form an image on the surface of the wafer, it is naturally necessary to move the wafer or the irradiation position. As such a moving method, various methods which are conventionally known can be used.

In the embodiment, the beam profile converter 5 is irradiated with the laser beam on the dot unit basis, which has passed through the liquid crystal mask 4. In the beam profile converter 5, optical components are arranged similarly in a matrix in correspondence with the liquid crystals arranged in a matrix of the liquid crystal mask 4. Therefore, laser beam passed through the liquid crystal mask 4 goes through the beam profile converter 5 on the pixel unit basis in a one-to-one corresponding manner, and the laser beam having the energy density distribution previously homogenized by the beam homogenizer 3 is converted into a laser beam having an energy density distribution necessary to form a minute dot mark shape peculiar to the invention. Although the energy density distribution of the laser beam passed through the liquid crystal mask 4 is converted into the required energy density distribution by allowing the laser beam having passed through the liquid crystal mask 4 to further pass through the beam profile converter 5 in the embodiment, there is also a case where the laser beam is directly led to the lens unit 6 without converting the profile of the energy density distribution by the beam profile converter 5.

The laser beam passed through the beam profile converter 5 is condensed to a predetermined position on the surface of the semiconductor wafer W by the lens unit 6, thereby performing the necessary dot marking onto the surface. In the embodiment, the maximum length of each pixel in the liquid crystal which is 50 to 2,000 μm is reduced to 1 to 15 μm on the surface of the semiconductor wafer W by the lens unit 6. In case of uniformly forming a dot mark of a micron unit onto the surfaces of a plurality of wafers, it is necessary to adjust the distance between the marking surface and a condensing lens and the optical axis on the micron unit. According to the embodiment, the focal point is detected by measuring the height in accordance with a confocal method which is generally used in a laser microscope or the like, the obtained value is fed back to a fine positioning mechanism in the vertical direction of the lens, and the focal point is positioned automatically. A generally known method is adopted for the optical axis adjustment and the positioning and adjustment of optical components. For example, the adjustment is performed by a screw adjusting mechanism for matching an object to a preset reference spot by using guide light of an He-Ne laser or the like. It is sufficient to carry out the adjustment only once at the time of assembly.

The maximum length of the minute dot mark on the marking surface according to the invention is therefore within the dimensional range from 1.0 to 15.0 μm. The protrusion/recess dimension is set to 0.01 to 5 μm in consideration of a case where the peripheral portion of the protrusion is slightly recessed. In order to form the dot mark having such a dimension, the length of one side of each dot in the liquid crystal mask 4 has to be 50 to 2,000 μm so as not to disturb a mark formation at the irradiation point on the surface of the semiconductor wafer W due to the limitation of the resolution of the condensing lens unit or the like. Further, when the interval between the beam profile converter 5 and the liquid crystal mask 4 is too large or too small, due to an influence of peripheral rays or an influence of instability of the optical axis, a mark formed on the surface of the semiconductor wafer tends to be disturbed. Therefore, in the embodiment, therefore, it is necessary to set the interval X between the beam profile converter 5 and the liquid crystal mask 4 to a value which is 0 to 10 times as long as the maximum length Y of each pixel in the liquid crystal mask 4. By setting the interval within such range, an image formed on the wafer surface becomes clear.

The beam profile converter 5 is an optical component for converting the energy density distribution homogenized by the beam homogenizer 3 into an optimum energy density distribution so as to obtain a dot shape peculiar to the invention. For example, by optionally varying a diffracting phenomenon, a refracting phenomenon, or a light transmittance at a laser irradiated point, the profile of the energy density distribution of an incident laser beam is converted into an arbitrary one. As the optical component, for instance, a diffraction optical element, a holographic optical element, a convex microlens array, or a liquid crystal itself can be used. Such elements or the like are arranged in a matrix and used as the beam profile converter 5.

The laser beam passed through the beam profile converter 5 is condensed by the image-formation lens unit 6 and then projected to an inner face of a notch portion of the semiconductor wafer W so that a necessary dot marking is carried out on that inner face. Conventionally, this kind of the dot marking is carried out on the surface of a peripheral portion or a back surface of the semiconductor wafer W as described above. In case of marking on such portions, because film thickness control on the peripheral portion of the wafer is difficult, film (specifically for metal series) is accumulated on the dot mark little by little each time when CMP processing is carried out, for example if etching is insufficient, thereby disabling reading of the dot. Alternatively, the film is to be removed completely, the wafer surface tends to be scraped out so that the dot mark depth is decreased thereby making it impossible to read the dot. Such an accident is fatal for a minute dot mark of micron unit.

In this respect, in the notch portion, scribe line and the peripheral face of the semiconductor wafer, not only the above mentioned peripheral face of the wafer can be avoided, but also processing such as film formation processing and film removal processing, which affects the visibility is not carried out positively. Thus, it is desirable that the dot marking is performed in an inner face of the notch portion, peripheral face of the wafer or surface of the scribe line. However, according to the conventional dot size, formation of a desired number of dots in these marking region is impossible. Thus, the aforementioned minute dot marking in micron unit is required.

In order to form such marking in the micron unit uniformly in the wafer surface, it is necessary to adjust a distance between the marking face and a condensing lens and an optical axis by unit of micron. According to this embodiment, a focal point is detected by measuring the height based on confocal method generally used in a laser microscope and the measured height of the focal point is fed back to a mechanism for determining a minute positioning in a vertical direction of the lens, so that the focal point is automatically positioned. For adjustment of optical axis and positioning and adjustment of optical components, a generally known method is applied, for example, a screw adjusting mechanism is used to adjust to a preset reference spot using a guide beam such as He-Ne laser. This adjustment has only to be carried out once during its assembling.

On the other hand, it has been apparent that the size of each dot of the dot mark depends on the wave length of a processing light source. Generally, it can be expressed that resolution of patterning is $k1 \cdot \lambda/NA$ and processing focal point depth (width of a distance in a focal point direction allowing processing) is $k1 \cdot \lambda/(NA)^2$ :
where k is a process factor (proportionality factor), $\lambda$ is wave length of light source and NA is an emission angle to the work surface.

It can be considered that in order to reduce the resolution for patterning, the wave length of the light source is reduced or the emission angle to a work is increased. However, the emission angle to the work surface is restricted to a certain value due to a relation with the focal depth. Therefore, it is desirable to use a laser beam having a short wave length in this invention.

Although conventionally, a basic wave of YAG laser (wave length: 1064 nm) is often used as a marking light source for the wafer, according to this embodiment, a laser beam source of twofold wave (wave length: 532 nm) or threefold wave (355 nm) relative to the YAG laser or a wave length in accordance with such wave length region is used.

If the minute dot marking is achieved in this manner, the focal depth is decreased correspondingly. On the other hand, marking on the semiconductor wafer surface is affected by an error in thickness of the wafer, warp or swelling of the wafer itself or positioning accuracy in the wafer handling. Therefore, the focal depth is affected largely. As a result, an automatic focal point determining means for automatically detecting and determining the focal point is absolutely necessary. As a detecting means for the focal point, the detection method based on the above mentioned general confocal microscope or triangulation measuring method can be used. In consideration of downsizing of the apparatus and measuring accuracy, it is preferable to use a triangulation measuring method. The aforementioned automatic positioning function is realized by carrying out a minute positioning based on feed back signals by means of the focal point detecting means.

The beam profile converter 5 is an optical component for converting the energy density distribution homogenized by the beam homogenizer 3 into an optimum energy density distribution so as to obtain a dot shape. For example, by arbitrarily varying a diffracting phenomenon, a refracting phenomenon or a light transmittance at a laser irradiated point, the profile of the energy density distribution of an incident laser beam is converted into an arbitrary dot mark shape.

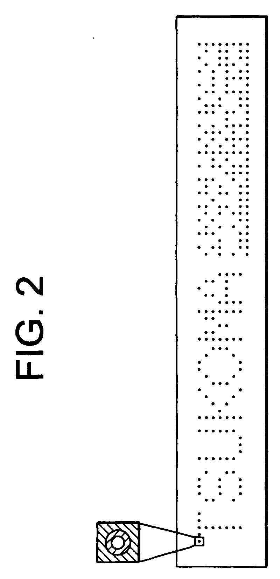

FIG. 2 shows an example of arrangement of single dot characters and 2D code marks formed on a scribe line of the semiconductor wafer W by the minute dot marks. This example indicates that the wave length of green laser of the laser beam is set to a green region, an expansion of the beam is set to less than 0.5 mrad and the pulse count is set to less than 100 ns. A diameter D of a dot mark formed on the scribe line is 5 μm.

On the other hand, although a scribe line SL is determined depending on the thickness of a dicing machine, it is currently considered that 50 to 60 μm is a limit. Then, according to this embodiment, assuming that the width of the scribe line SL is 50 μm which is a lower limit, a vertical length L1 and a lateral dimension L2 were set to 40 μm and 160 μm respectively, so that 8 x 32 dots can be formed in that region. Then, the 2D code mark is formed. Up to 13 alphanumeric characters can be registered by this 2D code. Further, 5 x 7 single dot marks are formed adjacent the aforementioned 2D code mark.

It is preferable that the dot mark to be formed on the dot mark formation surface according to the present invention has such a configuration that when coherent light or incoherent light or infrared ray is projected to the surface of the dot mark, a light reflected by that mark portion is scattered at its top. The dot mark having such a configuration is desired to be formed by the aforementioned laser marking apparatus and to be protruded upward from the dot mark formation surface.

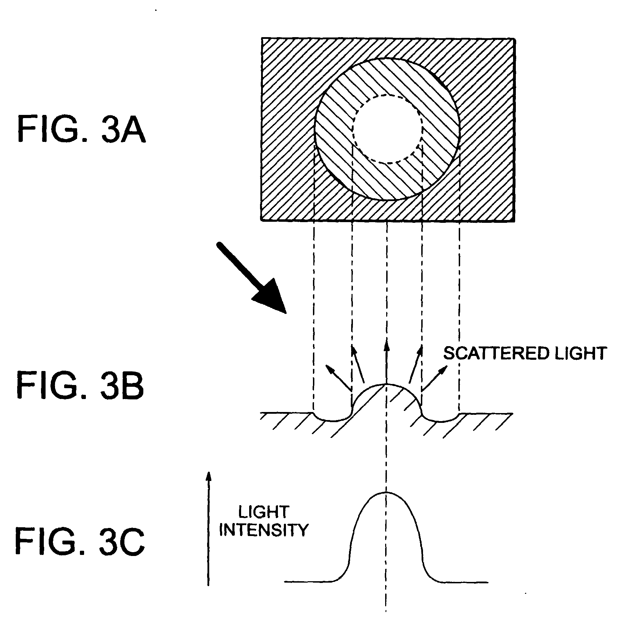

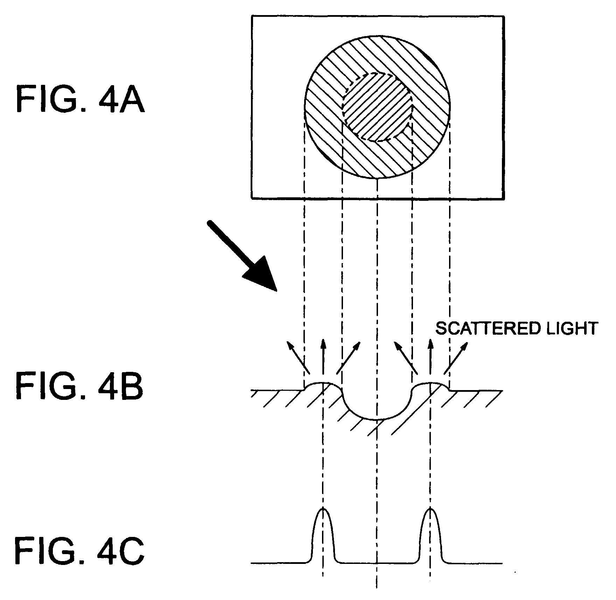

FIGS. 3A-3C and 4A-4C schematically show a configuration of a dot mark whose center portion is swollen upward and which is preferable in the present invention, and a configuration of a conventionally general dot mark which has a hole in the center thereof while its peripheral portion is swollen upward to be a ring like shape. These figures also show images taken by an image receiver installed just above an irradiated face when these dot marks are irradiated with beam similar to natural light projected obliquely from above the dot marks. From a configuration of the reflected surface of the dot mark shown in the figures, it can be understood as follows. That is, as for the configuration of the dot mark shown in FIG. 3B in which the reflected light is swollen largely in the center thereof, the entire swollen portion is taken as a reflected light having a high optical intensity as shown in FIG. 3C, so that an image having a very high brightness in the center as shown in FIG. 3A can be obtained. In case of the configuration of the conventional dot mark shown in FIG. 4B in which the center thereof is dented while the peripheral portion is swollen in a ring like shape, a reflected light of light projected obliquely from above forms a portion having a slightly higher optical intensity in the ring like shape and a bright portion outside thereof as shown in FIG. 4C. According to an optical image taken by the image receiver installed just above based on the scattered light, as shown in FIG. 4A, the center portion is the darkest and a bright portion expands from a ring-like brightness portion around that center portion to a brighter portion continuously.

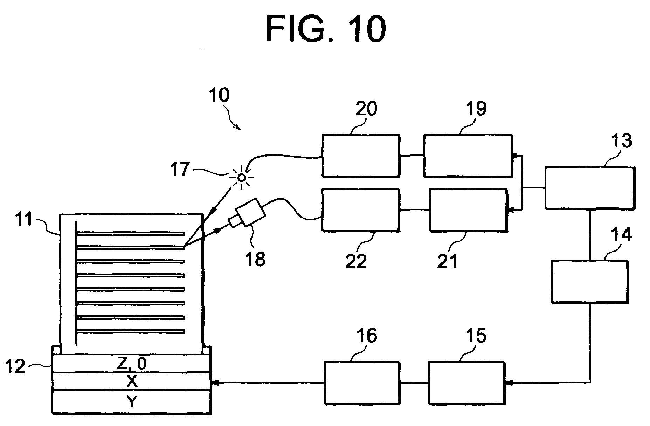

A dot mark formed actually by the above mentioned laser oscillator is compared to an optical image received by the mark reading apparatus of the present invention shown in FIG. 10. FIGS. 5 and 6 show optical images taken by photographing a minute dot mark, whose center portion is swollen, obliquely from above, which is applied to the present invention. FIG. 7 shows an optical image taken with respect to a conventional minute dot mark whose center portion is dented while having a ring-like swollen portion therearound.

It can be understood that a large difference occurs in clearness of the optical image depending on the configuration of the dot mark from these images. That is, the dot mark according to the present invention as shown in FIGS. 5 and 6 has an excellent visibility because the center portion is bright with a very high luminance, having a clear difference in brightness from the surrounding portions. Although the dot mark composed of the conventional hole configuration shown in FIG. 7 is more than four times as large as that of the present invention, the difference in luminance between the ring-like bright portion, the center portion and the surrounding portion is so small that the visibility is low.

In case where the photographed single dot mark image is processed as information of minimum unit, if the dot mark is a conventional one composed of such hole configuration, this a difference of luminance is recognized by comparing the dot mark to a model dot mark image stored in an image processing section through complicated arithmetic processing. In case of the dot mark image according to the present invention, a dot mark formation position can be specified by recognizing its single-point luminous region through only simple arithmetic processing, without a special arithmetic.

That is, according to the conventional dot mark reading, the dot mark, which is a minimum unit of information, is specified through complicated image processing such as production of a model image based on a photographed image, specification of information of photographed image by arithmetic operation and comparative arithmetic operation between the model image and specified configuration of photographed image. Thus, the conventional dot marks having small difference in luminance often cannot be read accurately. However, a single dot mark is a minimum unit which is to be processed to information by recognizing an arrangement position of plural dot marks and its configuration does not always have to be recognized.

In this respect, the dot mark according to this embodiment of the present invention is clearly distinguished because a difference of luminance and a difference of shade are concentrated to one point when it is read. Therefore, only through a simple image processing of only reading its luminance, a dot mark formation position which is minimum unit of information can be recognized accurately and easily.

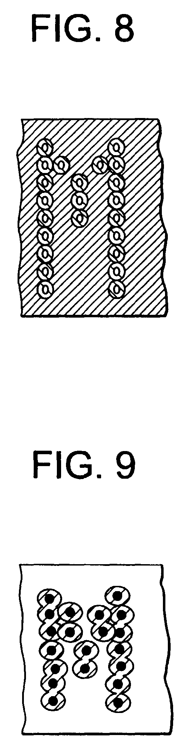

FIGS. 8 and 9 schematically show an optical image read by a reading apparatus of this embodiment in case where the dot marks are indicated as character information. As understood from these figures, the dot mark whose center portion is protruded is easy to recognize because the center portion has a very high luminance relative to the surrounding portions even if the high luminous point is slight. However, in the conventional dot mark composed of mainly a hole configuration, a difference in luminance (difference of brightness) between the center portion and the peripheral portion is small and further, the dot mark position is very difficult to recognize with only a dark portion in its center. Because of such a difference between the two, in case of the dot mark whose center portion is swollen, its visibility is not affected even if a gap between adjacent dot marks is reduced relative to the conventional example. However, in case of the dot mark whose center portion is dented, unless the gap between the adjacent dot marks is set larger than a predetermined size, its visibility is not secured. An influence by film formation and film removal upon the dot mark is severe so that the visibility is further reduced.

Next, a typical example of a reading apparatus and reading method of the present invention, which is preferable for the dot mark having a minute configuration whose center portion is swollen, will be described in detail.

FIG. 10 shows a schematic structure of a dot mark reading apparatus which is most efficient according to the present invention. Reference numeral 11 denotes a storage cassette for accommodating semiconductor wafers W. A plurality of the semiconductor wafers W are accommodated in parallel to each other with a predetermined gap, which is as well known.

Reference numeral 12 denotes a stage for positioning and fixing the aforementioned cassette 11. On the same stage 12, the cassette 11 is placed horizontally and fixed such that the wafers W accommodated therein are horizontal. The stage 12 can be moved in three directions, right/left direction (X-axis direction), back/forth direction (Y-axis direction) and vertical direction (Z-axis direction) by controlling. Further, it can be rotated around the Z-axis by controlling. These control operations are carried out by driving a motor driver section 16 through a stage control section 15 based on signals from a main control section 14 connected to an image processing section 13.

On the other hand, an irradiation light source (irradiation optical system) 17 and a CCD camera (image receiver) 18 are fixed at a predetermined position so as to be directed to one point on the peripheral face of an arbitrary wafer W of the plural semiconductor wafers W accommodated in the cassette 11. Adjustment of the irradiation amount of the irradiation light source 17 is carried out by controlling a irradiation light source 20 based on signals from an irradiation control section 19 of the image processing section 13. A focal point of the CCD camera 18 is controlled by a camera control section 22 by receiving signals from an image input section 21 of the image processing section 13.

According to this embodiment, an optical axis of the camera 18 is directed perpendicular to an inner face of the notch portion which is an irradiation surface and the irradiation light source 17 is disposed obliquely above at a predetermined angle with respect to an intersection between the optical axis of the camera 18 and the inner face of the notch portion. A relation between the camera 18 and the irradiation light source 17 may be inverted. According to the present invention, the light emitted from the irradiation light source 17 is desired to be incoherent light that is similar to natural light rather than coherent light as described above. However, it may be coherent light. In this embodiment, the camera 18 does not receive reflected light parallel having an even directivity but irregularly reflected lights in a predetermined region, which are irregularly reflected by the irradiation surface.

Such a relation between the irradiation and light reception does not require a strict positioning accuracy with regard to dispositions of the irradiation light source 17 and camera 18 so that it is advantageous because various dispositions can be set up. Further, when comparing the dot mark having the above mentioned protrusion in the notch portion of the semiconductor wafer W with the irradiation surface therearound, most of the irregularly reflected light received by the camera 18 is reflected by the surface of the dot mark. If this irregularly reflected light is received through a condensing lens (not shown), a difference in brightness between the center portion of the dot mark and the surrounding thereof increases so that the dot mark can be recognized securely.

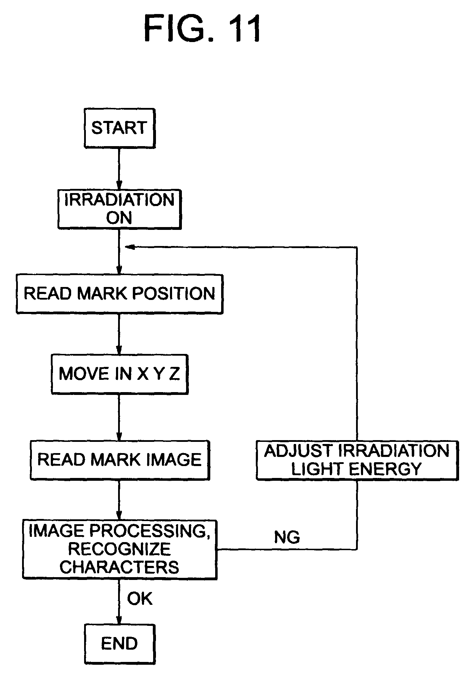

FIG. 11 shows a procedure for reading the dot marks by the device of this embodiment. When the irradiation power source 20 is turned on so that the irradiation light source 17 is lit, a region (the inner face of the notch portion) in which the dot mark is written is detected and the cassette 11 placed on the stage 12 is positioned. This positioning is achieved by moving the stage 12 in three directions, right/left direction (X-axis direction), back/forth direction (Y-axis direction) and vertical direction (Z-axis direction) and then rotated around the Z-axis by controlling and driving the motor driver section 16. After this positioning is finished, the camera 18 is operated so as to read the image of the dot marks. The image information is subjected to digital image processing so as to recognize the content of information. If the content of information is not recognized or the read image is unclear, the reading region of the notch inner face is detected again and the above mentioned operation is repeated.

When reading of the dot marks written into a single semiconductor wafer is finished, the stage 12 is moved vertically and the cassette 11 is moved up to have a surface reading region of a semiconductor wafer W to be read next opposed to the irradiation light source 17 and the camera 18. By repeating the above operations, the dot marks written in the notch portion of all the semiconductor wafers W accommodated in the cassette 11 are read out.

FIGS. 12 and 13 show a 3-dimensional view of arrangement and configurations of the minute dot marks whose center portions are protruded, observed by means of the AFM and a sectional view thereof.

According to these figures, each dot mark formed on an inner face of a notch portion of a semiconductor wafer W is a square of 3.6 μm, a height thereof is 0.33 μm and a gap between respective dots is 4.5 μm. Substantially conic dot marks of respective laser beams that have been divided in correspondence with each pixel of the liquid crystal mask 4 are formed on the inner face of the notch portion of the semiconductor wafer W. Further, 11 x 10 dot marks are arranged neatly and the heights thereof are substantially equal. This is because the energy distribution of the laser beam irradiated to the liquid crystal mask 4 is homogenized uniformly by the beam homogenizer 3.

As described above, light is projected to the dot marks, each of which is partially protruded from the marking face, and the scattered light by the protrusion is photographed by the CCD camera. If the protruding shape of the dot mark is a convex shape having a focal point O' internally, the scattered light is recognized as light scattered radially around the focal point O'. Thus, if the focal point of the CCD camera is set to the focal point O' in the dot mark, the optical image is photographed as a point having a very high brightness formed as a result of convergence of the scattered light likewise the above-described optical image.

As understood from FIG. 12, in the dot mark whose center portion is protruded having a typical dot configuration of the present invention, a top of the dot mark shines with a much higher brightness than the surrounding portion thereof despite its small height with respect to the diameter of the mark, so that the visibility is secured sufficiently. The above description is related to typical embodiments of the present invention and the same operation and effect of the present invention can be expected in photographing with X-ray or infrared ray camera as well as ordinary visible light. Further, the dot mark formation method should not be restricted to the above described embodiments.

## Claims

1. A dot mark reading apparatus, being characterized in that an electromagnetic wave is projected to a dot mark formation surface and its reflected wave or transmission wave is received by a wave receiver so as to read a dot mark by carrying out image processing of images sent from said wave receiver,

   at least part of said dot mark has a protruded portion which is protruded from said dot mark formation surface,
   said dot mark reading apparatus including:
   an electromagnetic wave projection system for projecting said electromagnetic wave obliquely from above or from just above to said dot mark;

the wave receiver for receiving scattered wave or transmission wave from said dot mark formation surface; and

an image processing means for carrying out image processing of image information from said wave receiver.

2. A dot mark reading apparatus according to claim 1, being characterized in that said image processing means has a recognition section for recognizing the scattered wave or transmission wave from said protruded portion of said dot mark as dot information of a minimum unit.

3. A dot mark reading apparatus according to claim 1 or 2, being characterized in that said electromagnetic wave is incoherent light.

4. A dot mark reading apparatus according to any of claims 1 to 3, being characterized in that said dot mark is formed on a peripheral face or an inner face of a notch portion of s semiconductor wafer (W),

said dot mark, reading apparatus further including:

a wafer cassette (11) which contains a plurality of said semiconductor wafers (W) each having part of the peripheral face exposed;

a stage (12) containing the cassette (11) placed horizontally, said stage (12) being moved in X-axis, Y-axis and Z-axis directions and rotated around its vertical axis; and

said electromagnetic wave projection system and said wave receiver disposed in a periphery of said cassette (11) so as to oppose an exposed peripheral face of one of the plurality of the semiconductor wafers (W) accommodated in said cassette (11).

5. A dot mark reading method, being characterized in that an electromagnetic wave is projected to a dot mark formation surface and reflected wave or transmission wave thereof are received by a wave receiver so as to read a dot mark by carrying out image processing of images sent from said wave receiver,

at least part of said dot mark has a protruded portion which is protruded from said dot mark formation surface,

said dot mark reading method including steps of:

projecting said electromagnetic wave on said mark dot formation surface through an electromagnetic wave projecting system;

receiving a scattered wave or transmission wave of said projected electromagnetic wave from said electromagnetic wave projection surface by means of the wave receiver: and

carrying out image processing of the electromagnetic wave received by said wave receiver as image information.

6. A dot mark reading method according to claim 5 further including a step of recognizing information corresponding to a single one of said dot mark of said image information as minimum information unit.

7. A dot mark reading method according to claim 5 or 6, being characterized in that the electromagnetic wave to be projected to said dot mark formation surface is incoherent light.

8. A dot mark reading method according to any of claims 5 to 7, being characterized in that a maximum width of said dot mark is 1 to 15 μm.

# FIG. 1

# FIG. 2

EP 1 073 097 A2

FIG. 3A

FIG. 3B

SCATTERED LIGHT

FIG. 3C

LIGHT
INTENSITY

FIG. 4A

FIG. 4B

SCATTERED LIGHT

FIG. 4C

# FIG. 5A

# FIG. 5B

10.00 × 10.00 [ μm ]

# FIG. 6A

C-D 211.95 [nm]

0.00                                                    9.41 [ μm]

# FIG. 6B

0.00

4.00

8.00

8.00

4.00

0.00

10.00 × 10.00 [ μm]

# FIG. 7A

C-D 37.25
[nm]

0.00
22.65 [μm]

# FIG. 7B

0.00
10.00
20.00
20.00
10.00
0.00

30.00×30.00 [μm]

# FIG. 8

# FIG. 9

# FIG. 10

# FIG. 11

```
        ┌──────────┐
        │  START   │
        └──────────┘
              │
              ▼
        ┌──────────┐
        │IRRADIATION│
        │    ON    │
        └──────────┘
              │        ◄──────────────────────┐
              ▼                                │
     ┌──────────────────┐                      │
     │ READ MARK POSITION│                     │
     └──────────────────┘                      │
              │                                │
              ▼                                │
     ┌──────────────┐                          │
     │ MOVE IN X Y Z │                         │
     └──────────────┘                          │
              │                                │
              ▼                                │
     ┌──────────────────┐      ┌──────────────────────┐
     │ READ MARK IMAGE  │      │  ADJUST IRRADIATION  │
     └──────────────────┘      │    LIGHT ENERGY      │
              │                └──────────────────────┘
              ▼                            ▲
     ┌──────────────────┐                  │
     │IMAGE PROCESSING, │  NG              │
     │   RECOGNIZE      │──────────────────┘
     │   CHARACTERS     │
     └──────────────────┘
              │ OK
              ▼
        ┌──────────┐
        │   END    │
        └──────────┘
```

# FIG. 12

0.00

20.00

49.5 μm
(=4.5×11 DOT)

40.00

60.00   0.00

60.00

40.00

45 μm
(=4.5×10 DOT)

20.00

62.50×62.50 [μm]

# FIG. 13

C-D   332.87 [nm]

0.00

53.70 [μm]

# FIG. 14